# EUROPÄISCHE PATENTANMELDUNG

(11) **EP 1 158 537 A2**
(43) Veröffentlichungstag der Anmeldung: **28.11.2001**
(21) Anmeldenummer: 01111059.0
(22) Anmeldetag: 08.05.2001
(51) Int. Cl.: G11C 17/18, G11C 17/14

(54) **Fuse-Schaltungsanordnung**

(30) Priorität: 26.05.2000 DE 10026253
(71) Anmelder: Infineon Technologies AG, 81669 München (DE)
(72) Erfinder: Hoenigschmid, Heinz, East Fishkill, NY 12524 (US)
(74) Vertreter: Müller . Hoffmann & Partner Patentanwälte

(57) **Zusammenfassung**

Die Erfindung betrifft eine Fuse-Schaltungsanordnung, bei der in der Auswerteschaltung (L) eine Kompensationskapazität (cc) vorgesehen wird, welcher einer parasitären Kapazität (Cp) zwischen einem Schalttransistor (n1) und der Fuse (F1) entgegenwirkt.

## Beschreibung

Die vorliegende Erfindung betrifft eine Fuse-Schaltungsanordnung aus einer Reihenschaltung von einem ersten Schalttransistor und einem zweiten Schalttransistor mit einer Fuse und einer an den Verbindungsknoten zwischen den beiden Schalttransistoren angeschlossenen Auswerteschaltung, an deren Ausgang der Zustand der Fuse abspeicherbar ist.

Fuse-Schaltungsanordnungen, wie insbesondere Fuse-Latches (-"Verriegeldungsglieder") werden bevorzugt in üblichen Speichern, wie beispielsweise DRAMs, FeRAMs, Flashes usw. zur Redundanz, Chip-Identifikation und für verschiedene weitere Einstellungen und Zwecke eingesetzt.

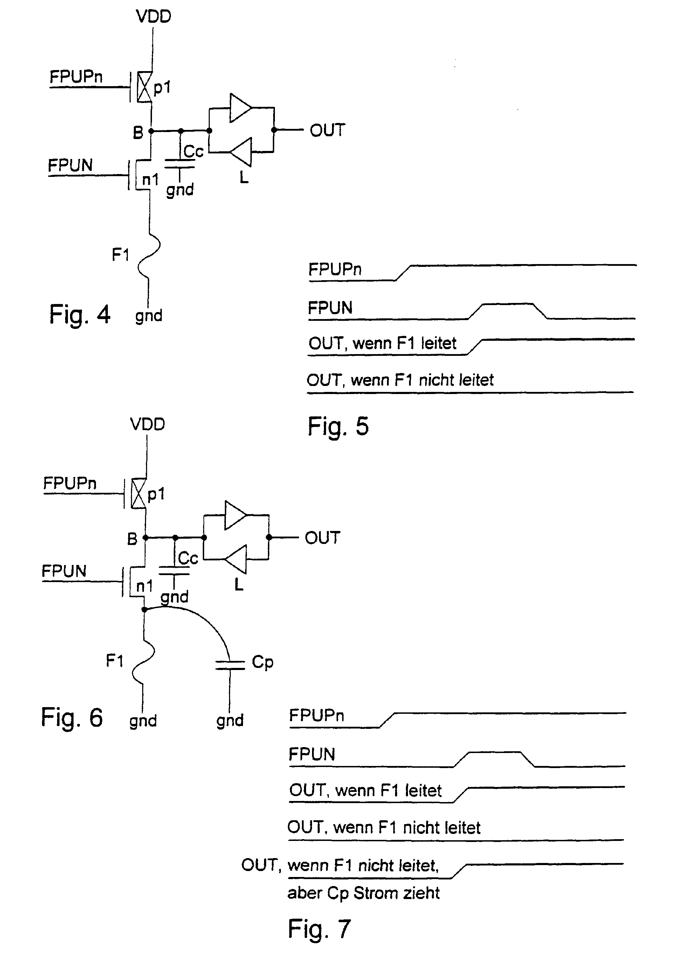

Eine derartige Fuse-Latch ist in Fig. 4 gezeigt: zwischen der Chip-Versorgungsspannung VDD und Masse gnd liegen ein p-Kanal-MOS-Feldeffekttransistor p1, ein n-Kanal-MOS-Feldeffekt-transistor n1 und eine Fuse F1 in Reihe. Der Transistor p1 ist durch ein Signal FPUPn angesteuert, während der Transistor n1 durch ein Signal FPUN angesteuert ist. Ein Knoten B zwischen den beiden Transistoren p1 und n1 ist mit einem Latch L verbunden, das einen Ausgang OUT hat.

Während der Initialisierung dieses Fuse-Latch wird zunächst das Steuersignal FPUPn auf niedrigem Niveau, d. h. aktiv gehalten, wodurch der Transistor p1 durchgeschaltet und in den leitenden Zustand gebracht wird. Dadurch wird der Knoten B auf die Spannung VDD aufgeladen und über das Latch L auf diesem Potential festgehalten. Am Ausgang OUT liegt das hierzu invertierte Potential gnd.

Sodann wird das Steuersignal FPUPn deaktiviert, d. h. auf das Potential VDD gezogen, und das Signal FPUN wird aktiviert, d. h. auf einen hohen Pegel gebracht. Dadurch wird der Transistor n1 kurzzeitig durchgeschaltet. Das Potential am Knoten B hängt nun davon ab, ob die Fuse F1 durchgängig, also leitend, oder geschossen, also nichtleitend, ist. Es sei angemerkt, daß anstelle einer Fuse auch eine Anti-Fuse eingesetzt werden kann. Eine Anti-Fuse ist nichtleitend und im geschossenen Zustand leitend.

Ist die Fuse F1 leitend, so wird der Knoten B auf das Potential gnd gezogen, während bei nichtleitender Fuse das vorangegangene Potential VDD beibehalten wird.

Das Latch L speichert diese Einstellung invertiert an seinem Ausgang OUT ab: ist die Fuse F1 nichtleitend, also der Knoten B auf dem Potential VDD, so ist der Ausgang OUT auf niedrigem Potential gnd, während bei leitender Fuse F1 der Knoten B auf Potential gnd ist und am Ausgang OUT das invertierte Potential VDD anliegt.

In Fig. 5 ist der Verlauf der Signale FPUPn und FPUN sowie der Potentialverlauf am Ausgang OUT bei leitender und nichtleitender Fuse F1 dargestellt.

Am Ausgang OUT wird so also eine Bewertung der Fuse-Information ("leitend" oder "nichtleitend", d. h. "nichtgeschossen" bzw. "geschossen" bei einer EFuse und "geschossen" bzw. "nichtgeschossen" bei einer Anti-Fuse) erhalten.

Bei der bestehenden Fuse-Schaltungsanordnung, wie diese in Fig. 4 gezeigt ist, kann es aufgrund parasitärer Kapazitäten zu einer Fehlbewertung der Fuse-Information kommen, was im folgenden anhand der Figuren 6 und 7 näher erläutert werden soll.

Ein parasitärer Kondensator Cp, der beispielsweise durch Flächen bzw. Leitungen im Layout der Schaltungsanordnung zwangsläufig entsteht, ist parallel zu der Fuse F1 geschaltet. Dieser parasitäre Kondensator Cp bewirkt dann ein Entladen des Knotens B selbst dann, wenn die Fuse F1 nichtleitend ist. Der parasitäre Kondensator Cp wird nämlich über den leitenden Transistor n1 bei nichtleitender Fuse F1 aufgeladen, wodurch eben der Knoten B entladen wird. Ist der Knoten B entladen, so liegt am Ausgang OUT das hohe Potential VDD. Das heißt, das Latch L kippt um, was zu einer Fehlbewertung des Zustandes der Fuse F1 führt. Dies ist aus Fig. 7 (siehe Zeilen 4 und 6) zu ersehen: am Ausgang OUT wird die gleiche Bewertung erhalten, wenn die Fuse F1 leitet und wenn die Fuse F1 nicht leitet.

Eine derartige Fehlbewertung macht die Fuse-Schaltungsanordnung unbrauchbar und für die Verwendung, beispielsweise in Speicheranordnungen, ungeeignet.

Es ist daher Aufgabe der vorliegenden Erfindung, eine Fuse-Schaltungsanordnung zu schaffen, bei der Fehlbewertungen infolge parasitärer Kapazitäten praktisch ausgeschlossen sind.

Diese Aufgabe wird bei einer Fuse-Schaltungsanordnung der eingangs genannten Art erfindungsgemäß durch eine an den Verbindungsknoten angeschlossene Kompensationskapazität, die einer zwischen der Verbindung zwischen dem zweiten Schalttransistor und der Fuse einerseits und Ground andererseits auftretenden, parasitären Kapazität entgegenwirkt, gelöst. Diese Kompensationskapazität kann in vorteilhafter Weise das Layout der Verbindung zwischen dem zweiten Schalttransistor und der Fuse nachbilden.

Bei der erfindungsgemäßen Fuse-Schaltungsanordnung wird also eine Kompensationskapazität am Knoten zwischen den beiden Schalttransistoren vorgesehen. Diese Kompensationskapazität wird zunächst auf das hohe Potential VDD aufgeladen. Dadurch kann der nötige Aufladestrom für die parasitäre Kapazität Cp aus der Kompensationskapazität gezogen werden, ohne daß ein Umkippen des Latch zu befürchten ist. Aus Platzgründen sollte die Kompensationskapazität nicht zu groß dimensioniert sein.

In vorteilhafter Weise sollte vielmehr die Kompensationskapazität etwa den gleichen Wert haben wie die parasitäre Kapazität. Dies kann beispielsweise dadurch erreicht werden, daß das Layout der Verbindung zwischen dem zweiten Schalttransistor und der Fuse auch in der Verbindung zwischen dem Knoten und dem Latch nachgebildet ist. Mit anderen Worten, das Layout der Fuse-Anordnung wird in der Auswerteschaltung so weit als möglich wiederholt, um dadurch die Kompensationskapazität zu generieren, welche der parasitären Kapazität entgegenwirkt.

Nachfolgend wird die Erfindung anhand der Zeichnungen näher erläutert. Es zeigen:

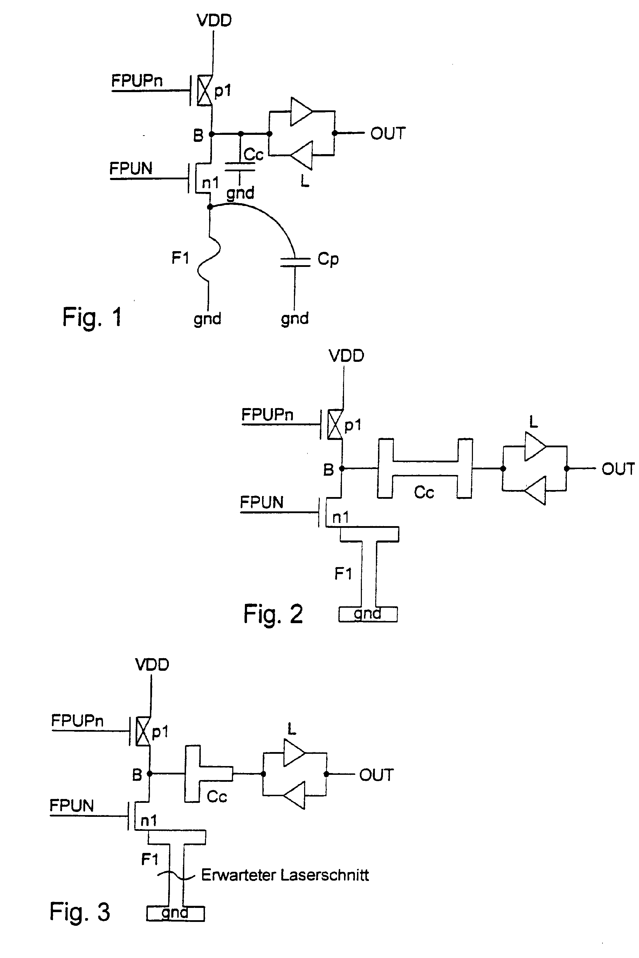

- Fig. 1: ein schematisches Schaltbild der erfindungsgemäßen Fuse-Schaltungsanordnung,
- Fig. 2: ein erstes Ausführungsbeispiel für das Layout der Kompensationskapazität,
- Fig. 3: ein zweites Ausführungsbeispiel für das Layout der Kompensationskapazität,
- Fig. 4: ein Schaltbild einer bestehenden Fuse-Schaltungsan-ordnung,
- Fig. 5: den Verlauf von Signalen bei der Fuse-Schaltungsan-ordnung von Fig. 4,
- Fig. 6: ein Fig. 4 entsprechendes Schaltbild mit einer zu-sätzlichen parasitären Kapazität, und
- Fig. 7: den Verlauf von Signalen bei der Fuse-Schaltungsan-ordnung von Fig. 6 mit zusätzlicher parasitärer Ka-pazität.

Die Figuren 4 bis 7 sind bereits eingangs erläutert worden. In den Figuren werden einander entsprechende Bauteile jeweils mit den gleichen Bezugszeichen versehen.

Wie aus Fig. 1 zu ersehen ist, liegt bei der erfindungsgemäßen Fuse-Schaltungsanordnung zwischen dem Knoten B, der die beiden Schalttransistoren p1 und n1 miteinander verbindet, und Ground gnd eine Kompensationskapazität Cc, die in vorteilhafter Weise etwa die gleiche Größe wie die parasitäre Kapazität Cp hat, welche zwischen dem Verbindungspunkt zwischen dem Transistor n1 und der Fuse F1 einerseits sowie Ground gnd andererseits auftritt. Ist die Fuse F1 nichtleitend, also geschossen, so wird der Aufladestrom für die zwangsläufig vorhandene parasitäre Kapazität Cp aus der Kompensationskapazität Cc über den Knoten B und den Transistor n1 gezogen. Dadurch kann eine Entladen des Knotens B verhindert werden, so daß dieser auf hohem Potential verbleibt. Am Ausgang OUT liegt dann der hierzu invertierte Zustand, also niedriges Potential, vor, was der Fall sein muß, wenn die Fuse F1 nicht leitet.

Eine Fehlbewertung des Zustandes der Fuse F1 am Ausgang OUT des Latches L kann so zuverlässig verhindert werden.

Die Figuren 2 und 3 zeigen noch vorteilhafte Ausgestaltungen für die Kompensationskapazität Cc. Diese Kompensationskapazität Cc soll, wie bereits oben erläutert wurde, das Layout der Verbindung zwischen dem Transistor n1 und Ground gnd über die Fuse F1 möglichst nachbilden. Hierzu wird die Kompensationskapazität Cc in ähnlicher Weise gestaltet wie der Leiterzug für die Verbindung zwischen diesem Transistor n1 und Ground gnd mit dem die Fuse F1 bildenden Metallstück, das eine Verjüngung hat, auf der ein Laser aufsetzen und zum Durchtrennen der Verjüngung schneiden kann.

In dem Ausführungsbeispiel von Fig. 2 wird dabei das komplette Metallstück der Fuse F1 auf die Kompensationskapazität Cc "abgebildet", so daß bei geschossener Fuse F1 eine Überkompensation vorliegen kann.

Dagegen wird beim Ausführungsbeispiel von Fig. 3 durch die Kompensationskapazität Cc das Layout der Schaltung bei einem erwarteten Laserschnitt nach Schießen der Fuse F1 nachgebildet. Das heißt, das Layout der Kompensationskapazität wird dadurch verkleinert, daß lediglich das nach dem Laserschnitt verbleibende Metallstück zur Verdrahtung benutzt wird.

## Patentansprüche

1. Fuse-Schaltungsanordnung aus einer Reihenschaltung von einem ersten Schalttransistor (p1) und einem zweiten Schalttransistor (n1) mit einer Fuse (F1) und einer an dem Verbindungsknoten (B) zwischen den beiden Schalttransistoren (p1, nl) angeschlossenen Auswerteschaltung (L), an deren Ausgang (OUT) der Zustand der Fuse (F1) abspeicherbar ist,
**gekennzeichnet durch**
eine an den Verbindungsknoten (B) angeschlossene Kompensationskapazität (Cc), die einer zwischen der Verbindung zwischen dem zweiten Schalttransistor (n1) und der Fuse (F1) einerseits und Ground (gnd) andererseits auftretenden, parasitären Kapazität (Cp) entgegenwirkt.

2. Fuse-Schaltungsanordnung nach Anspruch 1,
**dadurch gekennzeichnet,**
**daß** die Kompensationskapazität (Cc) das Layout der Verbindung zwischen dem zweiten Schalttransistor (n1) und der Fuse (F1) nachbildet.

3. Fuse-Schaltungsanordnung nach Anspruch 1 oder 2,
**dadurch gekennzeichnet,**
**daß** die Kompensationskapazität (Cc) im wesentlichen die gleiche Größe wie die parasitäre Kapazität (Cp) hat.

4. Fuse-Schaltungsanordnung aus einer Reihenschaltung von einem ersten Schalttransistor (p1) und einem zweiten Schalttransistor (n1) mit einer Fuse (F1) und einer an dem Verbindungsknoten (B) zwischen den beiden Schalttransistoren (p1, nl) angeschlossenen Auswerteschaltung (L), an deren Ausgang (OUT) der Zustand der Fuse (F1) abspeicherbar ist,
**gekennzeichnet durch**
eine zwischen dem Verbindungsknoten (B) und Ground (gnd) angeschlossene Kompensationskapazität (Cc), die einen Aufladestrom für eine zwischen der Verbindung zwischen dem zweiten Schalttransistor (n1) und der Fuse (F1) einerseits und Ground (gnd) andererseits auftretende, parasitäre Kapazität (Cp) liefert.
